# FASCICULE DE BREVET EUROPEEN

(11) **EP 3 317 820 B1**
(45) Date de publication et mention de la délivrance du brevet: **31.07.2019**
(21) Numéro de dépôt: 16745783.7
(22) Date de dépôt: 28.06.2016
(51) Int. Cl.: H01L 23/00, G06K 19/077

(54) **DOCUMENT ÉLECTRONIQUE TEL QU'UNE CARTE À PUCE À MÉTALLISATION RÉDUITE**
ELEKTRONISCHES DOKUMENT WIE EINE CHIPKARTE MIT REDUZIERTER METALLISIERUNG
ELECTRONIC DOCUMENT SUCH AS A CHIP CARD WITH REDUCED METALLIZATION

(30) Priorité: 30.06.2015 FR 1556119
(43) Date de publication de la demande: 09.05.2018
(73) Titulaire: IDEMIA France, 92400 Courbevoie (FR)
(72) Inventeur: GRAGNIC, Elodie, 92700 Colombes (FR); BOSQUET, Olivier, 92700 Colombes (FR)
(74) Mandataire: Santarelli
(86) Numéro de dépôt international: PCT/FR2016/051606
(87) Numéro de publication internationale: WO 2017/001771

(56) Documents cités:
- EP-A2- 2 637 129
- US-A- 6 107 920
- US-A1- 2015 161 501

## Description

L'invention concerne la constitution d'un document électronique comportant un corps dans lequel une cavité débouchant sur l'une des faces du corps contient un module qui doit être connecté à un composant contenu dans ce corps à distance de cette cavité. Ce composant peut notamment être une antenne, et le document peut être, notamment, une carte à puce de type bancaire, ou du type document d'identité tel que par exemple carte d'identité ou passeport. Selon l'invention, sa métallisation est réduite par rapport aux solutions existantes.

En pratique le corps est formé conjointement avec le composant, en ménageant une cavité, avant l'étape de fixation du module dans la cavité, appelée « étape d'encartage ».

De manière connue, le corps peut être formé par lamination d'un inlay sur lequel est formé le composant, notamment une antenne, entre deux couches en matière plastique ; la cavité comporte en pratique une portion centrale profonde entourée par une zone périphérique formée d'un lamage, de profondeur bien moindre que celle de la portion centrale, choisie en sorte que le module, une fois fixé dans la cavité, affleure la surface du corps de carte. Le composant est formé au sein du corps de manière à ce qu'il comporte des bornes de connexion situées sur la zone périphérique, au niveau du lamage. Cette cavité peut être préexistante, ou être usinée après lamination.

Toutefois, pour des raisons d'économie notamment, il a aussi été proposé de former le corps en une pièce, par exemple par moulage autour du composant, et d'usiner la cavité jusqu'à mettre à nu lesdites bornes de connexion.

De manière également connue, le module comporte un support plan de faible épaisseur comportant, sur une face dite face externe, une pluralité de zones externes de contact destinées à coopérer par contact avec des zones de contact d'un lecteur externe, et sur une face dite face interne, un circuit imprimé formé de pistes de connexion et un microcircuit (aussi appelé« circuit intégré », ou « puce ») connecté aux plages externes de contact par l'intermédiaire du circuit imprimé ; la connexion entre les bornes du microcircuit et le circuit imprimé peut être directe (dans le cas où les bornes du microcircuit sont sur la face du microcircuit qui fait face au support) ou être obtenue par des fils de connexion (dans le cas où les bornes du microcircuit sont à l'opposé du support, ce qui offre plus de souplesse compte tenu de la variété des géométries des microcircuits pouvant être implantés). Le circuit imprimé est connecté aux plages externes de contact au moyen de puits, c'est-à-dire des trous dans le support à travers lesquels sont passés des fils de connexion, ou des vias métallisés, c'est-à-dire au moyen de trous traversant le support sur toute son épaisseur en ayant leurs parois qui sont métallisées pour établir une liaison électrique entre les zones métallisées situées de part et d'autre du support à l'emplacement du via concerné. Le circuit imprimé comporte en pratique des zones métallisées situées près de sa périphérie qui sont connectées au microcircuit ; lors de l'encartage, le microcircuit est logé dans la portion profonde de la cavité, tandis que seules des portions du circuit imprimé s'étendent jusqu'à la zone périphérique de la face interne du support qui est destinée à être en regard du lamage de la cavité ; lesdites zones métallisées du circuit imprimé et les bornes du composant sont disposées de manière que, lors de l'encartage, elles soient en regard pour assurer une bonne liaison électrique entre le composant et le microcircuit. La connexion électrique entre ces zones et ces bornes se fait en pratique au moyen d'un matériau adhésif électriquement conducteur, de préférence anisotrope (c'est-à-dire conducteur selon une direction unique, à savoir une direction perpendiculaire à ces zones et à ces bornes).

On comprend que, pour garantir un haut niveau de fiabilité de la connexion électrique entre le composant et le microcircuit sans avoir à fixer des tolérances de positionnement des zones et bornes des tolérances d'encartage trop drastiques, il est généralement considéré comme nécessaire de former les bornes du composant et les zones métallisées situées à la périphérie du module sous la forme de pavés massifs métallisés.

Pour assurer la liaison entre le module et le corps, il a été proposé d'assurer la liaison mécanique par un adhésif et la liaison électrique par des ergots spécifiques (technique parfois appelée « bumps technology »). Toutefois, avec la tendance constante vers la miniaturisation, il est désormais courant d'utiliser un adhésif conducteur anisotrope, qui assure les deux types de liaison.

Il importe pourtant de noter que le matériau utilisé pour former les zones métallisées à relier électriquement est typiquement du cuivre, à savoir un métal dont le coût n'est pas négligeable, de sorte qu'il y aurait un intérêt financier significatif à pouvoir réduire la quantité de cuivre déposée sans réduire la fiabilité de la connexion électrique.

Le document US20150161501 A1 décrit un RFID dans lequel un module de puce est mis en contact avec les contacts d'antenne via un matériau électriquement conducteur. Les contacts d'antenne ont une forme sinueuse. Une colle séparée est utilisée pour fixer le module à la base de l'antenne.

Le document US6107920 décrit un RFID dans lequel un module de puce est mis en contact avec les contacts d'antenne via un adhésif électriquement conducteur anisotrope. Les contacts d'antenne ont une forme carrée solide.

L'invention a pour objet de répondre à cet objectif, plus généralement de minimiser les inconvénients des solutions connues.

L'invention se base sur un procédé de fabrication d'un document électronique selon la revendication 1 et un document électronique selon la revendication 6.

Elle propose à cet effet un procédé de fabrication d'un document électronique comportant les étapes suivantes :
- obtention d'un corps plan d'épaisseur constante, au moins 5 fois inférieure à sa longueur et à sa largeur, dans lequel est ménagée une cavité de forme globalement rectangulaire comportant une portion profonde entourée d'un lamage et qui contient un composant électronique ayant des bornes de connexion situées sur ce lamage,
- obtention d'un module comportant un support plan d'épaisseur au plus égale à la profondeur du lamage et muni, sur une face dite externe d'une pluralité de zones externes de contact et, sur une face dite interne d'un circuit imprimé formant des pistes de connexion et comportant des plots de connexion de forme massive en deux emplacements périphériques du support, ce circuit imprimé étant connecté à certaines au moins des zones externes de contact, le support étant en outre muni, sur cette face interne, d'un microcircuit connecté à ce circuit imprimé,
- encartage du module dans la cavité en sorte que les plots de connexion du module sont en regard des bornes de connexion du composant en définissant ensemble une surface de recouvrement/chevauchement, avec interposition entre le module et le lamage de la cavité d'un adhésif anisotropique électriquement conducteur, formé d'une pluralité de particules conductrice dans une matrice adhésive, assurant à la fois une liaison mécanique entre le module et le corps et une connexion électrique entre les bornes de connexion du composant et les plots de connexion du module,
caractérisé en ce que, les bornes de connexion du composant sont formées de méandres s'étendant parallèlement aux bords du lamage à distance des coins de ce lamage, et l'adhésif anistropiquement électriquement conducteur est choisi en sorte d'avoir un coefficient de recouvrement par les particules, de la surface de recouvrement, compris entre 5 et 8%.

Grâce à cette configuration en méandres, on peut obtenir une bonne connexion électrique, combinée à une bonne liaison mécanique, sans risquer de court-circuit, même dans le cas de modules de petite taille, tout en contrôlant la quantité de matériau de métallisation.

Selon des caractéristiques avantageuses de l'invention, éventuellement combinées :
- la cavité est obtenue par usinage après formation du corps contenant le composant, cet usinage mettant à nu les méandres à la surface du lamage ; cela a notamment pour avantage de combiner une technique de fabrication du corps de coût modéré et un procédé efficace de mise à nu des méandres,
- les méandres sont formés par un fil de diamètre compris entre 120 et 160 microns ; cela permet une réelle diminution de la quantité de matériau de métallisation nécessaire pour former les bornes de connexion, tout en faisant appel à des techniques déjà bien maîtrisées,
- les méandres sont formés par un fil de section circulaire noyé dans le corps, la cavité étant formée par usinage de ce corps, une étape de vérification étant prévue pour mesurer l'aire de ce fil mise à nu par l'usinage, l'étape d'encartage n'ayant lieu que sous réserve que cette aire représente au moins 2/3 de l'aire maximale pouvant être mise à nu par cet usinage ; cela permet de combiner un niveau élevé de fiabilité dans la surface à nu destinée à la connexion du module à des techniques de coût modéré,
- l'adhésif conducteur anisotrope est formé d'une matrice électriquement isolante contenant des particules conductrices de diamètre compris entre 20 et 60 microns, de préférence entre 30 et 50 microns, cet adhésif étant appliqué avec une épaisseur initiale comprise entre 35 et 100 microns ; de manière préférée, le rapport entre l'épaisseur initiale de la couche d'adhésif et le diamètre des particules est au moins approximativement compris entre 150 et 200%.

Selon un autre aspect, l'invention propose un document électronique comportant
- un corps plan d'épaisseur constante, au moins 5 fois inférieure à sa longueur et à sa largeur, dans lequel est ménagée une cavité de forme globalement rectangulaire comportant une portion profonde entourée d'un lamage et qui contient un composant électronique ayant des bornes de connexion situées sur ce lamage,
- un module comportant un support plan d'épaisseur au plus égale à la profondeur du lamage et muni, sur une face dite externe d'une pluralité de zones externes de contact et, sur une face dite interne d'un circuit imprimé formant des pistes de connexion et comportant des plots de connexion de forme massive en deux emplacements périphériques du support, ce circuit imprimé étant connecté à certaines au moins des zones externes de contact, le support étant en outre muni, sur cette face interne, d'un microcircuit connecté à ce circuit imprimé, ce module étant encarté dans la cavité en sorte que les plots de connexion du module sont en regard des bornes de connexion du composant en définissant ensemble une surface de recouvrement/chevauchement, avec interposition entre le module et le lamage de la cavité d'un adhésif anisotropiquement électriquement conducteur, formé d'une pluralité de particules conductrice dans une matrice adhésive, assurant à la fois une liaison mécanique entre le module et le corps et une connexion électrique entre les bornes de connexion du composant et les plots de connexion du module,

caractérisé en ce que, les bornes de connexion du composant sont formées de méandres s'étendant parallèlement aux bords du lamage à distance des coins de ce lamage, et l'adhésif anistropiquement électriquement conducteur a un coefficient de recouvrement par les particules, de la surface de recouvrement, compris entre 5 et 8%.

Selon d'autres caractéristiques avantageuses de l'invention, éventuellement combinées :
- L'adhésif conducteur anisotrope est formé d'une matrice électriquement isolante contenant des particules de diamètre compris entre 20 et 60 microns, cet adhésif ayant une épaisseur inférieure à ce diamètre ; cela signifie que les particules sont au moins en partie incrustées dans les zones métalliques qui sont à connecter électriquement,
- les méandres s'étendent sur une distance au moins approximativement égale à la dimension de la portion centrale profonde de la cavité qui est parallèle à ces méandres ; cela permet d'obtenir une surface significative sans risquer de réduire la tenue mécanique de la liaison du module dans la cavité,
- les méandres s'étendent sur une distance au maximum de 1,60mm selon une direction perpendiculaire à ces méandres et ont un espacement compris entre une et trois fois, de préférence entre deux et trois fois, la largeur de ces méandres ; cette valeur de 1.60 mm est de l'ordre de la largeur des lamages prévus pour des modules de petite taille ; en effet, l'invention trouve notamment son intérêt dans le cas de modules de petite taille, par exemple celui connu sous la désignation M3,
- la surface de recouvrement représente 20 à 30% de la surface des plots de connexion qui est en regard du lamage de la cavité,
- le document constitue une carte de forme rectangulaire, ce qui permet de profiter des techniques de fabrication parfaitement maitrisées à propos notamment des cartes de formats définis par les normes ISO 7816 et 14443, notamment le format connu sous la désignation 1FF des cartes de crédit ou bancaires,
- le composant est une antenne ; cela permet que le document puisse être de type dual, capable de communications par contact (au moyen des plages extérieures de contact) et sans contact (grâce à l'antenne),
- le module présente au maximum les dimensions : 8,5 mm ^{∗} 11 mm ; cela revient à dire que le module est d'un petit format par rapport à ce qu'on connait actuellement, par exemple au format M3.

Des objets, caractéristiques et avantages de l'invention ressortent de la description qui suit, donnée à titre d'exemple illustratif non limitatif, en regard des dessins annexés sur lesquels :
- La figure 1 est une vue de dessus de la cavité d'un corps de document électronique (non conforme à l'invention) visualisant le circuit imprimé d'un module monté dans cette cavité et plus particulièrement la zone de superposition entre des zones de connexion d'un composant contenu dans le corps et les plots de connexion du module,
- La figure 2 est une vue de dessus de la cavité d'un corps de documents électronique conforme à l'invention,
- La figure 3 est une vue similaire à celle de la figure 1, mais avec la cavité de la figure 2,
- La figure 4 est une photographie de la répartition des particules conductrices au sein d'un premier adhésif anisotropiquement électriquement conducteur, conforme à l'invention,
- La figure 5 est une photographie de la répartition des particules conductrices au sein d'un second adhésif anisotropiquement électriquement conducteur, non conforme à l'invention,
- La figure 6 est une photographie de la répartition des particules conductrices au sein d'un troisième adhésif anisotropiquement électriquement conducteur, non conforme à l'invention
- La figure 7 est une photographie de la répartition des particules conductrices au sein d'un quatrième adhésif anisotropiquement électriquement conducteur, non conforme à l'invention,
- La figure 8 est un schéma en coupe montrant un module sur le point d'être encarté dans un corps, pour former un document électronique conforme à l'invention, et
- La figure 9 est un schéma du résultat de l'encartage de la figure 8.

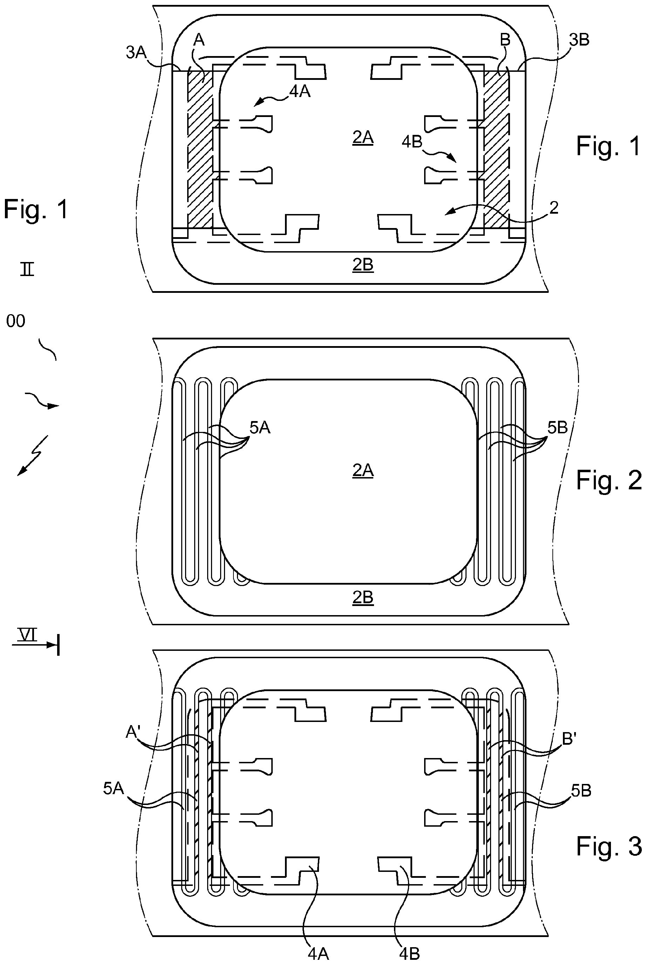

La figure 1 représente une partie d'un corps de document électronique, désignée sous la référence 1, dans laquelle une cavité 2 a été formée, en sorte de comporter une portion centrale 2A de grande profondeur, et une portion périphérique 2B de plus faible profondeur, en pratique constituée par un lamage. De manière habituelle, cette cavité a une forme globalement rectangulaire, avec des petits côtés, ici verticaux, et des grands côtés, ici horizontaux ; on observe une telle forme rectangulaire pour la portion centrale profonde de même que pour le lamage ; les coins de cette portion centrale et ceux du lamage sont arrondis. Par convention, des dimensions mesurées parallèlement aux petits côtés sont appelées « hauteurs ». Dans le cas où le document considéré est une carte à puce, les petits côtés du module sont parallèles aux petits côtés du corps de carte tandis que les grands côtés du module sont parallèles à de plus grands côtés du corps de carte.

Sur ce lamage sont formées des zones de connexion reliées à un composant (non représenté) intégré audit corps ; dans l'exemple ici considéré, ce composant est une antenne. Ces zones de connexion 3A et 3B sont massives et occupent toute la largeur du lamage, sur un peu moins de la totalité de la hauteur de la cavité (de l'ordre de 8/10ème).

En outre est représentée, sur cette figure 1, une forme possible pour des plots de connexion 4A et 4B prévus sur un module destiné à être monté dans la cavité ; plus précisément, ces plots de connexion ont la forme de peignes, avec une partie massive s'étendant suivant la hauteur de la cavité (sur environ de 80% à 90% de la hauteur de la partie profonde), et des pistes s'étendant à partir de cette partie massive vers l'autre plot en forme de peigne, parallèlement aux grands côtés de la cavité. Les zones hachurées A et B visualisent la surface de recouvrement entre les bornes du composant et les plots du module ; on peut apprécier que cette surface est massive. En fait, ces plots de connexion peuvent, en variante, ne plus être conformés en peigne comme cela est représenté sur cette figure 1, mais être plus simplement conformés de manière massive en ayant une plus grande dimension suivant une direction horizontale de la figure 1 (cela explique pourquoi on peut parler de largeur pour désigner des dimensions parallèles à cette direction).

Un module destiné à être monté dans la cavité a une forme très proche de celle de la cavité au niveau du lamage, en légèrement plus petit pour assurer un jeu de montage.

Le module peut comporter deux séries de zones externes de contact, longeant les petits côtés du module ; dans une configuration mise au point dans une démarche de miniaturisation des modules et des cartes à puce, le module peut, en variante, comporter deux séries de trois plages de contacts et présenter les dimensions maximum de 8,5mm selon une première direction Y et 11mm selon une deuxième direction X, avec (ou sans) deux autres plages de contact. Cela correspond à un format habituellement désigné sous le sigle M3 tout particulièrement visé par l'invention.

Pour minimiser la quantité de cuivre utilisée pour former les bornes de connexion du composant, il est proposé, selon un aspect de l'invention, que ces bornes soient constituées par des méandres électriquement conducteurs 5A et 5B ; on voit sur la figure 2 que ces méandres s'étendent parallèlement aux bords du lamage, suivant la hauteur définie ci-dessus. On comprend aisément que, dans le cas particulier où le composant est une antenne, ces méandres peuvent être simplement un prolongement des pistes de l'antenne ; ces pistes peuvent être formées d'un fil incrusté dans le corps ou de pistes déposées par tout moyen approprié. Cette notion de méandre peut aussi être définie en disant que ces bornes de connexion sont constituées par des extrémités en zigzag, ou en serpentin des pistes de connexion au composant (ou des extrémités de celui-ci).

La réduction de la quantité de cuivre peut ainsi être tout à fait significative ; elle dépend de la largeur des méandres et leur espacement ; dans l'exemple représenté, la réduction peut dépasser 65%.

Si l'on compare la figure 3 avec la figure 1, on voit que la surface de recouvrement entre les méandres 5A ou 5B et les plots de connexion du module (voir les zones A' et B') est bien plus faible, d'autant que, dans l'exemple représenté seuls certains des méandres participent à ce recouvrement (sur les quatre méandres qu'on peut identifier sur la figure 2, seuls deux sont en regard des plots du module). La réduction est d'environ d'un facteur 3. Il faut noter à cet égard que la surface de recouvrement, dans cette configuration en méandres, peut varier au sein des tolérances habituellement acceptées en ce qui concerne le positionnement des bornes de connexion (désormais constituées par ces méandres) sur les lamages et le positionnement du module lors de l'encartage. Dans le cas d'un module ayant les dimensions standard désignées sous la mention M3, il apparaît ainsi qu'un décalage, lors de l'encartage de 1 à 1.5 mm vers le haut ou vers le bas, ou de 0.1 à 0.2 mm vers la droite ou vers la gauche (en référence à la figure 3), peut faire varier la surface de recouvrement de plus de 10%.

Les bornes de connexion formées par de tels méandres (en pratique entre deux et cinq méandres) ont une largeur au plus égale à la largeur du lamage, ce qui correspond à un maximum de 1.60 mm pour un module de type M3.

On peut noter que le rapport 3 précité correspond au fait que l'écartement entre deux méandres est de l'ordre du double de la largeur des pistes ; selon l'invention, ce rapport vaut avantageusement entre 1 et 3 (c'est-à-dire que l'espacement entre deux méandres vaut entre une fois et trois fois, de préférence entre deux fois et trois fois, la largeur des pistes conductrices formant les méandres). En effet pour des fils conducteurs de diamètre minimum 110µm, l'usinage fait apparaître une section d'environ 100µm de largeur. L'intervalle de dépose minimum est de 300µm, soit un écartement de 300-100=200µm. Il en ressort un rapport de 2. Cette valeur augmente avec le diamètre du fil, dans la mesure où l'intervalle est aussi augmenté lors de l'incrustation du fil dans le corps en plastique.

On comprend aisément que le choix d'une telle conformation des bornes de connexion en méandres ou en zigzag, du fait de la réduction drastique de la surface de recouvrement, serait a priori récusé par un homme de métier soucieux de garantir, malgré des cadences élevées de production et une éventuelle miniaturisation des cavités et des modules, une grande fiabilité des connexions électriques entre le module et le microcircuit.

Il est toutefois apparu que, sous réserve d'utiliser un adhésif conducteur anistrope (on parle parfois de ACF en abrégé, pour « anisotropic conducting adhesive ») bien choisi, on pouvait garantir une bonne conduction électrique malgré cette réduction drastique de la surface de recouvrement.

On dit que l'adhésif est anisotrope en ce sens qu'il n'assure une conductivité électrique que suivant une direction, à savoir une direction perpendiculaire aux surfaces à relier mécaniquement ; il est en fait plus exact de dire que cet adhésif est anisotropiquement électriquement conducteur.

Ce caractère anisotrope est obtenu au moyen de particules conductrices distribuées au sein d'une matrice adhésive électriquement isolante ; les particules sont au moins approximativement sphériques avec des diamètres au moins approximativement égaux.

Les particules, ou billes, sont au moins électriquement conductrices en surface, par exemple revêtues d'une couche d'argent ; leur masse peut être elle-même métallique (par exemple en cuivre) ou non, par exemple en un polymère. Quant à la matrice, elle est habituellement formée d'un matériau thermofusible, par exemple un polyester ou un polyamide.

Parmi les caractéristiques de tels adhésifs conducteurs anisotropes on peut citer notamment le coefficient de recouvrement, défini comme étant, après assemblage, en se référant à l'interface entre les surfaces à relier, le rapport entre la surface occupée par les particules conductrices et la surface occupée par l'adhésif; pour ce faire on prend acte de ce que, lors de l'encartage, les particules s'incrustent dans les zones conductrices (en cuivre le plus souvent, comme indiqué ci-dessus). Le taux d'incrustation recommandé est de 70% du diamètre des particules pour garantir une bonne connexion. En fait, au vu des très petites dimensions des particules, le postulat retenu ici est que les particules présentent une surface de contact égale à la section de diamètre correspondant à celui des particules. Ainsi, la contribution d'une particule à la surface de contact est égale à sa section maximale. De plus, pour une particule de 30µm de diamètre, l'épaisseur résiduelle d'adhésif recommandée est de 20µm, car l'adhésif flue sur les côtés et diminue en épaisseur jusqu'à atteindre une épaisseur inférieure ou égale à l'épaisseur des particules.

On comprend que le caractère anisotrope de l'adhésif implique que les particules sont normalement efficacement distantes les unes des autres et que le taux de recouvrement n'est pas trop élevé pour assurer un bon maintien mécanique ; à l'inverse, si le taux de recouvrement est trop faible, l'adhésif n'assure une connexion électrique que sur une faible fraction de la surface de recouvrement des zones métallisées à connecter.

On comprend que, pour caractériser un adhésif conducteur anisotrope, on peut utiliser un dispositif d'imagerie connu en soi, pour mettre en évidence, par contraste, des particules conductrices dans une couche d'un tel adhésif, compter ces particules sur une surface donnée de cette couche et en déduire un coefficient de recouvrement tel que défini ci-dessus.

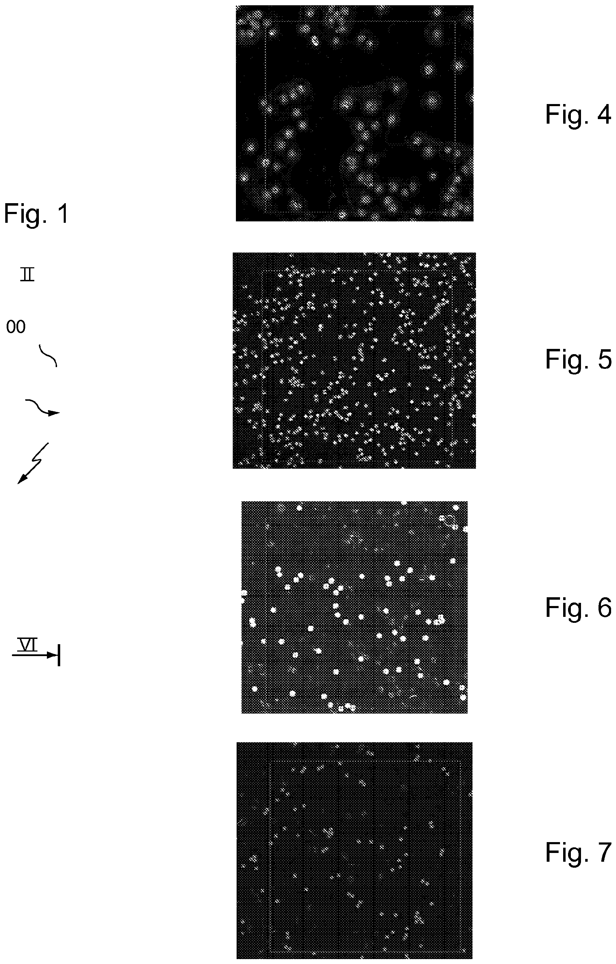

Les photos des figures 4 à 7 correspondent à quatre adhésifs conducteurs anisotropes définis comme suit :
- La figure 4 correspond à un premier adhésif, avec une épaisseur initiale de 70 microns et des particules de 40 microns de diamètre, à raison de 57 particules par mm² ; cela correspond à un taux de recouvrement de 1/14 soit 7.1%; on observe une répartition presque régulière de particules assez grosses,
- La figure 5 correspond à un deuxième adhésif avec une épaisseur de 35 microns et des particules de 20 microns de diamètre, à raison de 300 particules par mm² ; cela correspond à un taux de recouvrement de 1/10 soit 10% ; on observe une répartition presque homogène de petites particules,
- La figure 6 correspond à un troisième adhésif avec une épaisseur de 50 microns et des particules de 30 microns de diamètre, à raison de 50 particules par mm² ; cela correspond à un taux de recouvrement de 1/30 soit 3.3% ; on observe une répartition inhomogène (les différences d'apparence traduisent une différence de profondeur des particules dans l'adhésif), laissant des zones libres de toute particule,
- La figure 7 correspond à un quatrième adhésif avec une épaisseur de 35 microns et des particules de 20 microns de diamètre, à raison de 100 particules par mm² ; cela correspond à un taux de recouvrement de 1/30 soit 3.3% ; on observe une répartition inhomogène de petites particules, laissant apparaître des zones vides de toute particule,

Des tests d'encartage dans la configuration de la figure 3 ont été effectués et ont conduit aux résultats suivants :
- 1^{er} échantillon : tests satisfaisants
- 2ème échantillon : décollement module
- 3ème échantillon : perte de connexion électrique dans un test dit de déformation de la carte dans le sens de la hauteur (petit côté)
- 4ème échantillon : perte de connexion électrique pour le teste évoqué ci-dessus.

Ainsi, seul le premier adhésif est apparu satisfaisant ;
- le comportement insuffisant du second semble imputable, toutes choses étant égales par ailleurs, au trop grand nombre de particules qui fragilisent le collage ;
- le comportement insuffisant du troisième semble imputable à l'inhomogénéité et la faible répartition des particules, et
- le comportement insuffisant du quatrième semble imputable également à l'inhomogénéité et la faible répartition des particules.

Il est à noter que le choix de l'épaisseur d'adhésif (lié au choix de la taille de particules) a un impact également sur la position du module dans le corps de carte ; plus l'épaisseur est importante, plus les zones externes de contact risquent de venir en saillie par rapport à la surface du corps ; inversement, une réduction de l'épaisseur peut conduire au fait que le module soit en retrait par rapport à cette surface.

On peut retenir de ce qui précède qu'il convient de choisir un adhésif dont les particules sont régulièrement réparties et qui correspondent à un taux de recouvrement de plus de 5%, mais moins de 10%, de préférence pas plus de 8%. La taille de particules est de préférence comprise entre 20 et 60 microns, par exemple entre 30 et 60 microns, voire 30 et 50 microns. Il semble en outre préférable de retenir des adhésifs correspondant à des épaisseurs suffisantes pour assurer une adhésion régulière sur la totalité du lamage, malgré les irrégularités de surface induites par la présence des zones métallisées ; cela tend à recommander des adhésifs prévus pour être appliqués avec des épaisseurs initiales d'au moins 35 microns, par exemple comprises entre 35 et 100 microns. Après l'étape d'encartage, qui est une étape de pressage à chaud, l'épaisseur de l'adhésif diminue par un phénomène de fluage et présente alors une épaisseur égale ou inférieure à celle des particules. Le taux de recouvrement précité combiné avec les dimensions précitées correspond à une densité de particules qui est de préférence comprise entre 50 et 100 par mm², voire 80 par mm².

De manière générale, on utilise de préférence des adhésifs dont les particules ont un diamètre choisi entre 20 et 60 microns, de préférence entre 30 et 50 microns et l'adhésif est appliqué avec une épaisseur initiale comprise entre 35 et 100 microns ; en pratique, on applique la couche d'adhésif avec une épaisseur initiale de préférence comprise entre de l'ordre de 150% et 200% du diamètre des particules ; après mise en place, la couche d'adhésif peut avoir une épaisseur ne valant plus qu'une fraction du diamètre des particules, par exemple de l'ordre de 2/3, voire de l'ordre de 1/2.

L'ensemble de ces caractéristiques permet de définir un optimum pour garantir une bonne connexion électrique, malgré la petite surface de cuivre des extrémités du composant, et une bonne liaison mécanique sur un module de petite taille.

Voici quelques valeurs de surfaces de connexion en fonction du type d'adhésif et de l'une ou l'autre de deux géométries pour les bornes de connexion (soit une forme massive, soit une configuration en zigzag) :
- 1er adhésif : la surface en configuration de zigzag est de 0.095 mm² au lieu de 0.295 mm² avec des bornes massives,
- 2ème adhésif : la surface en configuration de zigzag est de 0.132 mm² au lieu de 0.412 mm²
- 3ème adhésif : la surface en configuration de zigzag est de 0.044 mm² au lieu de 0.137 mm² et
- 4ème adhésif : la surface en configuration de zigzag est de 0.44 mm².

De manière à augmenter le taux de recouvrement entre les plots de connexion du module et les bornes en zigzag du composant, il est avantageux d'augmenter la hauteur desdites bornes, c'est à dire de former ces zigzags sur environ toute la hauteur de la portion profonde de la cavité, par exemple à 5% près (voir la figure 2). Par contre, des tests ont montré que, si les méandres s'étendent au-delà, c'est-à-dire jusque dans les coins du lamage, la liaison mécanique se dégrade.

Compte tenu des dimensions standard des modules habituellement utilisés et des cavités destinées à les recevoir, on aboutit à préconiser une hauteur de 6.5 mm comme étant un bon compromis entre bonne connexion électrique et bonne liaison mécanique.

L'invention s'applique particulièrement bien lorsque la surface de recouvrement représente avantageusement 20% à 30% de la surface d'un plot de connexion qui est en regard du lamage bordant la cavité (il peut être utile de faire la moyenne entre les valeurs correspondant aux deux bornes de connexion).

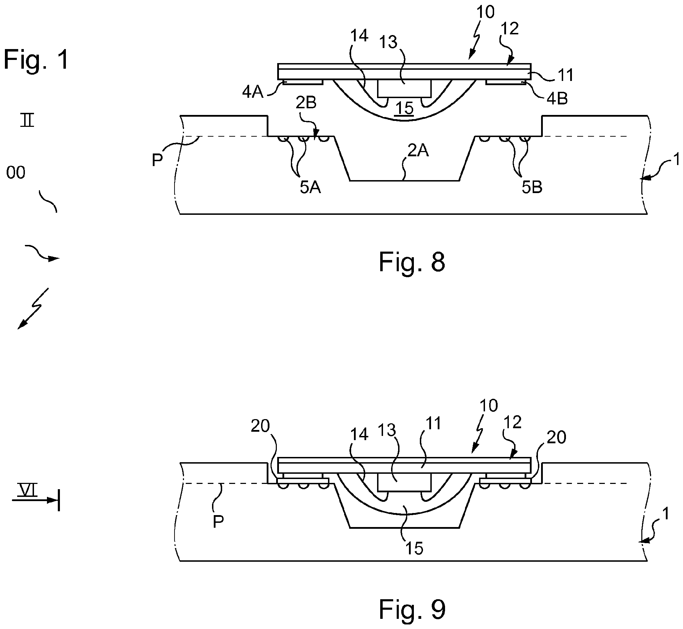

La figure 8 représente le module des figures 1 ou 3 sur le point d'être encarté à l'intérieur de la cavité du corps 1.

Comme indiqué à propos des figures 1 et 3, ce module, noté 10, comporte avantageusement, pour des raisons d'économie de cuivre combinées à des raisons de miniaturisation, des plots de connexion situées sur les petits côtés et conformées en forme de peigne. Ces plots de connexion font partie d'un circuit imprimé (non représenté ici) formé sur une face interne d'un support 11 portant, sur sa face externe (tournée vers le haut) une pluralité de zones externes de contact notées 12 dans leur ensemble ; sur la face interne est en outre fixé un microcircuit 13 formant la « puce » relié au circuit imprimé par des liaisons filaires 14 classiquement formées de fils d'or. Le microcircuit 13 et les fils sont classiquement intégrés à une masse de résine 15.

Le lamage 2B de la cavité est longé par des méandres 5A et 5B reliés à un composant intégré au corps 1. De manière avantageuse, ce composant est une antenne formée de spires formées dans un plan situé à une profondeur donnée dans le corps, schématisé par une ligne en pointillés notée P.

Ce corps peut être formé d'un inlay sur une face duquel a été formée cette antenne et laminé avec au moins une couche de recouvrement pour obtenir l'intégration de l'antenne à l'intérieur du corps ; dans un tel cas, la cavité peut être formée dans cette couche de recouvrement après l'opération de lamination.

Toutefois, le corps peut en outre être formé en une seule pièce, par surmoulage sur le composant, ici les spires de l'antenne, d'une matière formant le corps (en complément d'un éventuel support du composant). Dans un tel cas, la cavité peut être formée après un tel surmoulage, par un usinage effectué jusqu'à mettre à nu les méandres 5A et 5B.

Lorsque les méandres sont formés d'un fil de section habituellement circulaire, on comprend que, selon la profondeur réelle de l'usinage, la section mise à nu de ce fil est plus ou moins importante, avec un maximum lorsque l'usinage a mis à nu le fil dans un plan passant par l'axe du fil, c'est-à-dire mettant à nu une section de largeur égale au diamètre du fil.

De manière avantageuse, avant de procéder, en phase de production industrielle, à l'encartage d'un module à l'intérieur d'une cavité ainsi formée par usinage jusqu'à, en ce qui concerne les bornes de connexion, la profondeur de fils conducteurs, on vérifie que l'aire de cuivre ainsi mise à nu est suffisamment grande pour établir, avec l'adhésif conducteur anisotrope choisi, une bonne connexion électrique.

En fait, on peut prévoir, avant même de choisir un tel adhésif, une telle étape de mesure de l'aire de cuivre mise à nu, de manière à évaluer une plage de valeurs pouvant être obtenues pour cette aire, et d'en déduire les caractéristiques que doit avoir un adhésif conducteur anisotrope pour pouvoir assurer efficacement une bonne connexion électrique et une bonne liaison mécanique. Cette étape préalable permet, une fois que l'adhésif a été choisi, de déterminer l'aire minimale que l'usinage doit, en production en série, avoir mis à nu pour garantir que l'adhésif va assurer une bonne connexion électrique entre le composant et le microcircuit.

On comprend que l'aire pouvant être obtenue dépend de la précision de l'usinage (de manière à s'arrêter précisément au niveau où la section du fil est maximale), mais aussi du diamètre de ce fil et de l'écartement entre les méandres de ce fil ; ainsi, lors de cette phase de mise au point, on peut décider de retoucher la géométrie des méandres des bornes de connexion du composant. En pratique, puisqu'on utilise avantageusement un même fil pour former des spires d'antenne et des bornes de connexion d'une telle antenne, les diamètres de fil sont, dans le cas d'un composant constitué d'une antenne, avantageusement choisis entre 120 et 160 microns.

En fait, cette étape préalable peut aussi être faite par calcul, en déterminant l'aire maximale qui peut être mise à nu, compte de la configuration choisie pour les méandres formant les bornes de connexion. L'aire minimale à mettre à nu peut alors être évaluée, par exemple une valeur comprise entre 50% et 75% de l'aire maximale pouvant être obtenue, par exemple à de l'ordre de 2/3, ou de 70%.

A titre d'exemple, s'il est constaté que l'aire maximale pouvant être mise à nu par usinage vaut 1.32 mm² la valeur minimale peut être choisie entre 0.8mm² et 1 mm² selon la marge de sécurité qu'on accepte de se donner. De telles valeurs peuvent notamment être choisies, en combinaison avec des modules dont les plots de connexion ont des aires de 4.50 à 5.00 mm², notamment 4.75 mm².

Si l'étape de vérification révèle une aire mise à nu inférieure au seuil choisi, le corps de carte peut être mis au rebut sans y effectuer le moindre encartage ; en variante, la mise au rebut peut être effectuée à une étape ultérieure, après encartage, si cela est plus efficace et plus économique.

A titre d'exemple, cette étape de vérification est effectuée au moyen d'une caméra rapide, par exemple de type « Sherlock », placée en sortie d'un poste d'usinage, pour capter une image de chaque cavité ; un logiciel lié à la caméra transforme l'image ainsi captée en une valeur d'aire de connexion (typiquement par discrimination entre les zones claires, attribuées aux zones conductrices, et les zones plus sombres, attribuées aux zones occupées par la matière plastique formant le corps du document (ou corps de carte). Si l'aire ainsi détectée pour chacune des bornes de connexion d'une cavité donnée n'est pas au moins égale au seuil choisi, le corps sera ultérieurement rebuté.

Un corps de document peut ainsi être mis au rebut pour plusieurs raisons, par un usinage pas assez profond, un mauvais brossage de la surface de matériau conducteur, un arrachement du fil conducteur, etc.

On comprend aisément qu'un document électronique obtenu par le procédé est identifiable à partir des caractéristiques relatives des bornes de connexion et de l'adhésif utilisé.

On le reconnait ainsi, notamment, par la présence entre ses plots et ses bornes de connexion d'une couche d'adhésif 20 ayant les propriétés mentionnées ci-dessus.

En pratique, l'adhésif peut être appliqué indifféremment sur le lamage ou sur la périphérie du module.

Un document électronique conforme à l'invention est plan en ce que son épaisseur, constante, vaut au moins 5 voire 10 fois moins que ses autres dimensions. Dans le cas d'une carte à puce de type bancaire, le rapport vaut même de l'ordre du centième de sa plus grande dimension, et moins du cinquantième de sa largeur.

Ainsi que cela a déjà été mentionné, le module a avantageusement un petit format, égal ou inférieur à celui défini par les dimensions de 8.5 mm ^{∗} 11 mm.

## Revendications

1. Procédé de fabrication d'un document électronique comportant les étapes suivantes :
- obtention d'un corps plan d'épaisseur constante, au moins 5 fois inférieure à sa longueur et à sa largeur, dans lequel est ménagée une cavité (2) de forme globalement rectangulaire comportant une portion profonde (2A) entourée d'un lamage (2B) et qui contient un composant électronique ayant des bornes de connexion situées sur ce lamage,
- obtention d'un module comportant un support plan d'épaisseur au plus égale à la profondeur du lamage et muni, sur une face dite externe d'une pluralité de zones externes de contact et, sur une face dite interne d'un circuit imprimé formant des pistes de connexion et comportant des plots de connexion (4A, 4B) de forme massive en deux emplacements périphériques du support, ce circuit imprimé étant connecté à certaines au moins des zones externes de contact, le support étant en outre muni, sur cette face interne, d'un microcircuit connecté à ce circuit imprimé,
- encartage du module dans la cavité en sorte que les plots (4A, 4B) de connexion du module sont en regard des bornes (5A, 5B) de connexion du composant en définissant ensemble une surface de recouvrement/chevauchement, avec interposition entre le module et le lamage de la cavité d'un adhésif anisotropique électriquement conducteur, formé d'une pluralité de particules conductrice dans une matrice adhésive, assurant à la fois une liaison mécanique entre le module et le corps et une connexion électrique entre les bornes de connexion du composant et les plots de connexion du module,
**caractérisé en ce que**, les bornes de connexion du composant sont formées de méandres (5A, 5B, 20) s'étendant parallèlement aux bords du lamage à distance des coins de ce lamage, et l'adhésif anistropiquement électriquement conducteur est choisi en sorte d'avoir un coefficient de recouvrement, par les particules, de la surface de recouvrement, compris entre 5 et 8%.

2. Procédé selon la revendication 1, selon lequel la cavité est obtenue par usinage après formation du corps contenant le composant, cet usinage mettant à nu les méandres à la surface du lamage.

3. Procédé selon l'une quelconque des revendications précédentes selon lequel les méandres sont formés par un fil de diamètre compris entre 120 et 160 microns.

4. Procédé selon l'une quelconque des revendications 1 à 3, selon lequel les méandres sont formés par un fil de section circulaire noyé dans le corps, la cavité étant formée par usinage de ce corps, une étape de vérification étant prévue pour mesurer l'aire de ce fil mise à nu par l'usinage, l'étape d'encartage n'ayant lieu que sous réserve que cette aire représente au moins 2/3 de l'aire maximale pouvant être mise à nu par cet usinage..

5. Procédé selon l'une quelconque des revendications 1 à 4, dans lequel l'adhésif conducteur anisotrope est formé d'une matrice électriquement isolante contenant des particules de diamètre compris entre 20 et 60 microns, cet adhésif étant appliqué avec une épaisseur initiale comprise entre 35 et 100 microns.

6. Document électronique comportant
un corps plan d'épaisseur constante, au moins 5 fois inférieure à sa longueur et à sa largeur, dans lequel est ménagée une cavité (2) de forme globalement rectangulaire comportant une portion profonde (2A) entourée d'un lamage (2B) et qui contient un composant électronique ayant des bornes de connexion (5A, 5B) situées sur ce lamage,
un module comportant un support plan d'épaisseur au plus égale à la profondeur du lamage et muni, sur une face dite externe d'une pluralité de zones externes de contact et, sur une face dite interne d'un circuit imprimé formant des pistes de connexion et comportant des plots de connexion (4A, 4B) de forme massive en deux emplacements périphériques du support, ce circuit imprimé étant connecté à certaines au moins des zones externes de contact, le support étant en outre muni, sur cette face interne, d'un microcircuit connecté à ce circuit imprimé, ce module étant encarté dans la cavité en sorte que les plots (4A, 4B) de connexion du module sont en regard des bornes (5A, 5B) de connexion du composant en définissant ensemble une surface de recouvrement/chevauchement, avec interposition entre le module et le lamage de la cavité d'un adhésif anisotropiquement électriquement conducteur, formé d'une pluralité de particules conductrice dans une matrice adhésive, assurant à la fois une liaison mécanique entre le module et le corps et une connexion électrique entre les bornes de connexion du composant et les plots de connexion du module,
**caractérisé en ce que**, les bornes de connexion (5A, 5B) du composant sont formées de méandres s'étendant parallèlement aux bords du lamage à distance des coins de ce lamage, et l'adhésif anistropiquement électriquement conducteur a un coefficient de recouvrement, par les particules, de la surface de recouvrement, compris entre 5 et 8%.

7. Document selon la revendication 6, dans lequel l'adhésif conducteur anisotrope est formé d'une matrice électriquement isolante contenant des particules de diamètre compris entre 20 et 60 microns, cet adhésif étant appliqué avec une épaisseur initiale comprise entre 35 et 100 microns.

8. Document selon la revendication 6 ou la revendication 7, selon lequel les méandres s'étendent sur une distance au moins approximativement égale à la dimension de la portion centrale profonde de la cavité qui est parallèle à ces méandres.

9. Document selon l'une quelconque des revendications 6 à 8, selon lequel les méandres s'étendent sur une distance au maximum de 1,60mm selon une direction perpendiculaire à ces méandres et ont un espacement compris entre deux et trois fois la largeur de ces méandres.

10. Document selon l'une des revendications 6 à 9, dans lequel la surface de recouvrement représente 20 à 30% de la surface d'un plot de connexion qui est en regard du lamage de la cavité.

11. Document selon l'une des revendications 6 à 10 constituant une carte de forme rectangulaire.

12. Document selon l'une des revendications 6 à 11 dont le composant est une antenne.

13. Document électronique selon l'une des revendications 6 à 12 dans lequel le module présente les dimensions : 8,5 mm ^{∗} 11mm.

## Patentansprüche

1. Verfahren zur Herstellung eines elektronischen Dokuments, umfassend die folgenden Schritte:
- Herstellung eines ebenen Körpers mit konstanter Dicke, die mindestens 5-mal kleiner als seine Länge und seine Breite ist, in dem ein Hohlraum (2) von global rechteckiger Form ausgespart ist, umfassend einen tiefen Abschnitt (2A), der von einer Senkung (2B) umgeben ist, und der eine elektronische Komponente enthält, die Anschlussklemmen aufweist, die sich auf dieser Senkung befinden,
- Herstellung eines Moduls, umfassend einen ebenen Träger mit einer Dicke höchstens gleich der Tiefe der Senkung, der auf einer so genannten Außenseite mit einer Vielzahl von externen Kontaktzonen und auf einer so genannten Innenseite mit einer gedruckten Schaltung versehen ist, die Anschlussspuren bildet und Anschlussstücke (4A, 4B) von massiver Form an zwei peripheren Stellen des Trägers umfasst, wobei diese gedruckte Schaltung an mindestens gewisse der externen Kontaktzonen angeschlossen ist, wobei der Träger ferner auf dieser Innenseite mit einer Mikroschaltung versehen ist, die an diese gedruckte Schaltung angeschlossen ist,
- Einstecken des Moduls in den Hohlraum, so dass die Anschlussstücke (4A, 4B) des Moduls gegenüber den Anschlussklemmen (5A, 5B) der Komponente angeordnet sind, wobei gemeinsam eine Abdeckungs-/Überlappungsfläche definiert wird, wobei zwischen das Modul und die Senkung des Hohlraums ein anisotropes elektrisch leitendes Haftmittel zwischengefügt wird, das von einer Vielzahl von leitenden Partikeln in einer Haftmatrix gebildet ist und sowohl eine mechanische Verbindung zwischen dem Modul und dem Körper als auch einen elektrischen Anschluss zwischen den Anschlussklemmen der Komponente und den Anschlussstücken des Moduls gewährleistet,
**dadurch gekennzeichnet, dass** die Anschlussklemmen der Komponente von Mäandern (5A, 5B, 20) gebildet sind, die sich parallel zu den Rändern der Senkung in einem Abstand zu den Ecken dieser Senkung erstrecken, und das anisotrope elektrisch leitende Haftmittel derart ausgewählt ist, dass ein Überdeckungskoeffizient der Überdeckungsfläche durch die Partikel zwischen 5 und 8 % beträgt.

2. Verfahren nach Anspruch 1, bei dem der Hohlraum durch Bearbeitung nach Formung des die Komponente enthaltenden Körpers erhalten wird, wobei diese Bearbeitung die Mäander der Oberfläche der Senkung freilegt.

3. Verfahren nach einem der vorhergehenden Ansprüche, bei dem die Mäander von einem Draht mit einem Durchmesser zwischen 120 und 160 Mikrometer gebildet sind.

4. Verfahren nach einem der Ansprüche 1 bis 3, bei dem die Mäander von einem Draht mit kreisförmigem Querschnitt gebildet sind, der in den Körper versenkt ist, wobei der Hohlraum durch Bearbeitung dieses Körpers gebildet wird, wobei ein Überprüfungsschritt vorgesehen ist, um den Bereich dieses Drahts, der durch die Bearbeitung freigelegt wird, zu messen, wobei der Schritt des Einsteckens nur vorbehaltlich dessen stattfindet, dass dieser Bereich mindestens 2/3 des maximalen Bereichs ausmacht, der durch diese Bearbeitung freigelegt werden kann.

5. Verfahren nach einem der Ansprüche 1 bis 4, bei dem das anisotrope leitende Haftmittel von einer elektrisch isolierenden Matrix gebildet ist, die Partikel mit einem Durchmesser zwischen 20 und 60 Mikrometer enthält, wobei dieses Haftmittel mit einer Anfangsdicke zwischen 35 und 100 Mikrometer aufgetragen wird.

6. Elektronisches Dokument, umfassend
einen ebenen Körper mit konstanter Dicke, die mindestens 5-mal kleiner als seine Länge und seine Breite ist, in dem ein Hohlraum (2) von global rechteckiger Form ausgespart ist, umfassend einen tiefen Abschnitt (2A), der von einer Senkung (2B) umgeben ist, und der eine elektronische Komponente enthält, die Anschlussklemmen (5A, 5B) aufweist, die sich auf dieser Senkung befinden,
ein Modul, umfassend einen ebenen Träger mit einer Dicke höchstens gleich der Tiefe der Senkung, der auf einer so genannten Außenseite mit einer Vielzahl von externen Kontaktzonen und auf einer so genannten Innenseite mit einer gedruckten Schaltung versehen ist, die Anschlussspuren bildet und Anschlussstücke (4A, 4B) von massiver Form an zwei peripheren Stellen des Trägers umfasst, wobei diese gedruckte Schaltung an mindestens gewisse der externen Kontaktzonen angeschlossen ist, wobei der Träger ferner auf dieser Innenseite mit einer Mikroschaltung versehen ist, die an diese gedruckte Schaltung angeschlossen ist, wobei dieses Modul in den Hohlraum eingesteckt wird, so dass die Anschlussstücke (4A, 4B) des Moduls gegenüber den Anschlussklemmen (5A, 5B) der Komponente angeordnet sind, wobei gemeinsam eine Abdeckungs-/Überlappungsfläche definiert wird, wobei zwischen das Modul und die Senkung des Hohlraums ein anisotropes elektrisch leitendes Haftmittel zwischengefügt wird, das von einer Vielzahl von leitenden Partikeln in einer Haftmatrix gebildet ist und sowohl eine mechanische Verbindung zwischen dem Modul und dem Körper als auch einen elektrischen Anschluss zwischen den Anschlussklemmen der Komponente und den Anschlussstücken des Moduls gewährleistet,
**dadurch gekennzeichnet, dass** die Anschlussklemmen (5A, 5B) der Komponente von Mäandern gebildet sind, die sich parallel zu den Rändern der Senkung in einem Abstand zu den Ecken dieser Senkung erstrecken, und das anisotrope elektrisch leitende Haftmittel einen Überdeckungskoeffizient der Überdeckungsfläche durch die Partikel zwischen 5 und 8 % aufweist.

7. Dokument nach Anspruch 6, bei dem das anisotrope leitende Haftmittel von einer elektrisch isolierenden Matrix gebildet ist, die Partikel mit einem Durchmesser zwischen 20 und 60 Mikrometer enthält, wobei dieses Haftmittel mit einer Anfangsdicke zwischen 35 und 100 Mikrometer aufgetragen wird.

8. Dokument nach Anspruch 6 oder Anspruch 7, bei dem sich die Mäander über eine Distanz mindestens annähernd gleich der Dimension des tiefen zentralen Abschnitts des Hohlraums, der zu diesen Mäandern parallel ist, erstreckt.

9. Dokument nach einem der Ansprüche 6 bis 8, bei dem sich die Mäander über eine Distanz von höchstens 1,60 mm in eine Richtung senkrecht auf diese Mäander erstrecken und einen Abstand zwischen zwei- und dreimal die Breite dieser Mäander haben.

10. Dokument nach einem der Ansprüche 6 bis 9, bei dem die Überdeckungsfläche 20 bis 30 % der Oberfläche eines Anschlussstücks, das der Senkung des Hohlraums gegenüberliegt, aufweist.

11. Dokument nach einem der Ansprüche 6 bis 10, das eine Karte von rechteckiger Form darstellt.

12. Dokument nach einem der Ansprüche 6 bis 11, dessen Komponente eine Antenne ist.

13. Elektronisches Dokument nach einem der Ansprüche 6 bis 12, bei dem das Modul die Abmessungen: 8,5 mm x 11 mm aufweist.

## Claims

1. Method for manufacturing an electronic document, comprising the following steps:
- obtaining a flat body with a constant thickness, at least 5 times smaller than its length and than its width, in which body is formed a cavity (2) of rectangular overall shape having a deep portion (2A) surrounded by a counterbore (2B) and that contains an electronic component having connection terminals that are situated on this counterbore,
- obtaining a module having a flat carrier with a thickness at most equal to the depth of the counterbore and equipped, on a face termed external face, with a plurality of external contact zones and, on a face termed internal face, with a printed circuit forming connection tracks and having connection pads (4A, 4B), in solid form, at two peripheral locations of the carrier, this printed circuit being connected to at least some of the external contact zones, the carrier furthermore being equipped, on this internal face, with a microcircuit connected to this printed circuit,
- inlaying the module into the cavity, such that the connection pads (4A, 4B) of the module face the connection terminals (5A, 5B) of the component and together define an area of coverage/overlap, with interposition, between the module and the counterbore of the cavity, of an electrically conductive anisotropic adhesive formed of a plurality of conductive particles in an adhesive matrix and providing both a mechanical link between the module and the body and an electrical connection between the connection terminals of the component and the connection pads of the module,
**characterized in that** the connection terminals of the component are formed by meanders (5A, 5B, 20) extending parallel to the edges of the counterbore at a distance from the corners of this counterbore, and the anisotropically electrically conductive adhesive is chosen so as to have a coefficient of overlap, by the particles, of the area of overlap, of between 5 and 8%.

2. Method according to Claim 1, wherein the cavity is obtained by machining after the body containing the component has been formed, this machining exposing the meanders at the surface of the counterbore.

3. Method according to either one of the preceding claims, wherein the meanders are formed by a wire with a diameter of between 120 and 160 microns.

4. Method according to any one of Claims 1 to 3, wherein the meanders are formed by a wire with a circular cross section that is embedded in the body, the cavity being formed by machining this body, a checking step being provided to measure the area of this wire exposed by the machining, the inlaying step taking place only under the proviso that this area represents at least 2/3 of the maximum area that is able to be exposed by this machining.

5. Method according to any one of Claims 1 to 4, wherein the anisotropic conductive adhesive is formed of an electrically insulating matrix containing particles with a diameter of between 20 and 60 microns, this adhesive being applied with an initial thickness of between 35 and 100 microns.

6. Electronic document having
a flat body with a constant thickness, at least 5 times smaller than its length and than its width, in which body is formed a cavity (2) of rectangular overall shape having a deep portion (2A) surrounded by a counterbore (2B) and that contains an electronic component having connection terminals (5A, 5B) that are situated on this counterbore,
a module having a flat carrier with a thickness at most equal to the depth of the counterbore and equipped, on a face termed external face, with a plurality of external contact zones and, on a face termed internal face, with a printed circuit forming connection tracks and having connection pads (4A, 4B), in solid form, at two peripheral locations of the carrier, this printed circuit being connected to at least some of the external contact zones, the carrier furthermore being equipped, on this internal face, with a microcircuit connected to this printed circuit, this module being inlaid into the cavity, such that the connection pads (4A, 4B) of the module face the connection terminals (5A, 5B) of the component and together define an area of coverage/overlap, with interposition, between the module and the counterbore of the cavity, of an anisotropically electrically conductive adhesive formed of a plurality of conductive particles in an adhesive matrix and providing both a mechanical link between the module and the body and an electrical connection between the connection terminals of the component and the connection pads of the module,
**characterized in that** the connection terminals (5A, 5B) of the component are formed by meanders extending parallel to the edges of the counterbore at a distance from the corners of this counterbore, and the anisotropically electrically conductive adhesive has a coefficient of overlap, by the particles, of the area of overlap, of between 5 and 8%.

7. Document according to Claim 6, wherein the anisotropic conductive adhesive is formed of an electrically insulating matrix containing particles with a diameter of between 20 and 60 microns, this adhesive being applied with an initial thickness of between 35 and 100 microns.

8. Document according to Claim 6 or Claim 7, wherein the meanders extend over a distance at least approximately equal to the dimension of the deep central portion of the cavity that is parallel to these meanders.

9. Document according to any one of Claims 6 to 8, wherein the meanders extend over a distance of at most 1.60 mm in a direction perpendicular to these meanders, and have a spacing of between two and three times the width of these meanders.

10. Document according to one of Claims 6 to 9, wherein the area of overlap represents 20 to 30% of the area of a connection pad that faces the counterbore of the cavity.

11. Document according to one of Claims 6 to 10, forming a card of rectangular shape.

12. Document according to one of Claims 6 to 11, the component of which is an antenna.

13. Electronic document according to one of Claims 6 to 12, wherein the module has dimensions of: 8.5 mm ^{∗} 11 mm.
